# EUROPEAN PATENT APPLICATION

(11) **EP 4 633 331 A1**
(43) Date of publication of application: **15.10.2025**
(21) Application number: 25168772.9
(22) Date of filing: 07.04.2025
(51) Int. Cl.: H10K 10/46, H10D 30/47, H10K 85/60

(54) **SEMICONDUCTOR DEVICE INCLUDING TWO-DIMENSIONAL MATERIAL AND METHOD OF MANUFACTURING THE SAME**

(30) Priority: 08.04.2024 US 202463575973 P; 14.06.2024 KR 20240077756
(71) Applicant: SAMSUNG ELECTRONICS CO., LTD., Yeongtong-gu Suwon-si, Gyeonggi-do 16677 (KR); The University of Chicago, Chicago, Illinois 60637 (US)
(72) Inventor: SEOL, Minsu, 16678 Suwon-si (KR); KWON, Junyoung, 16678 Suwon-si (KR); RYU, Huije, 16678 Suwon-si (KR); CHOWDHURY, Tomojit, Chicago, 60637 (US); PARK, Jiwoong, Chicago, 60637 (US); LIANG, Ce, Chicago, 60637 (US); MUJID, Fauzia, Chicago, 60637 (US)
(74) Representative: Elkington and Fife LLP

(57) **Abstract**

A semiconductor device may include a channel layer (130) including a two-dimensional material layer (110) and a molecular crystal layer (120) on the two-dimensional material layer, the two-dimensional material layer including a two-dimensional semiconductor material; a source electrode (151) and a drain electrode (152), which respectively may be on both sides of the channel layer; and a gate insulating layer (140) and a gate electrode (160), which respectively may be on the channel layer between the source electrode and the drain electrode. The molecular crystal layer may include a plate-shaped aromatic compound of C₂₀-C₄₀, and may have a thickness of 1 molecular layer to 5 molecular layers.

## Description

### FIELD OF THE INVENTION

The disclosure relates to a semiconductor device including a two-dimensional material and/or a method of manufacturing the same.

### BACKGROUND OF THE INVENTION

As miniaturization progresses to increase the integration of semiconductor devices, performance limitations due to scaling of 3D bulk materials may appear. For example, in the case of silicon channels, as channel thickness decreases, mobility may decrease, and dispersion of threshold voltages (Vth) may increase. As channel length decreases, performance degradation due to short-channel effects may increase.

To overcome these scaling limitations, research is being conducted using two-dimensional semiconductor materials. Channels made of two-dimensional semiconductor materials not only exhibit improved performance even at a thickness of 1 nm or less, but also may have smaller short-channel effects than silicon, thereby overcoming the scaling limitations of silicon.

### SUMMARY OF THE INVENTION

Provided are a semiconductor device including a two-dimensional semiconductor material and/or a method of manufacturing the same.

Additional aspects will be set forth in part in the description which follows and, in part, will be apparent from the description, or may be learned by practice of the presented embodiments of the disclosure.

According to an example embodiment, a semiconductor device may include a channel layer including a two-dimensional material layer and a molecular crystal layer on the two-dimensional material layer, the two-dimensional material layer including a two-dimensional semiconductor material; a source electrode and a drain electrode, which respectively may be on both sides of the channel layer; and a gate insulating layer and a gate electrode on the channel layer between the source electrode and the drain electrode. The molecular crystal layer may include a plate-shaped aromatic compound of C₂₀-C₄₀, and a thickness of the molecular crystal layer may be 1 molecular layer to 5 molecular layers.

In some embodiments, the plate-shaped aromatic compound may have semiconductor characteristics.

In some embodiments, the plate-shaped aromatic compound may include a tetracene-based compound, a chrysene-based compound, a triphenylene-based compound, a pyrene-based compound, a perylene-based compound, a pentacene-based compound, a benzopyrene-based compound, a benzoperylene-based compound, or a coronene-based compound.

In some embodiments, the plate-shaped aromatic compound may include at least one of a hydroxyl group, a carboxyl group, a metal carboxylate group, an imide group, an amide group, and a carboxylic anhydride group.

In some embodiments, the molecular crystal layer may have a thickness of 1 molecular layer to 3 molecular layers, for example, 2 molecular layers to 3 molecular layers.

In some embodiments, the two-dimensional semiconductor material may have a band gap of 0.1 eV to 3.0 eV.

In some embodiments, the two-dimensional semiconductor material may include a transition metal dichalcogenide (TMD) or black phosphorus.

In some embodiments, the transition metal dichalcogenide (TMD) may include a metal element and a chalcogen element. The metal element may include at least one of Mo, W, Nb, V, Ta, Ti, Zr, Hf, Tc, and Re. The chalcogen element may include at least one of S, Se, and Te.

In some embodiments, the transition metal dichalcogenide (TMD) may include MoS₂, MoSe₂, MoTe₂, WS₂, WSe₂, WTe₂, ZrS₂, ZrSe₂, HfS₂, HfSe₂, NbSe₂, ReSe₂ or any combination thereof.

In some embodiments, the two-dimensional material layer may include 1 molecular layer to 10 molecular layers, for example, 2 molecular layers to 8 molecular layers, 3 molecular layers to 7 molecular layers, or 4 molecular layers to 6 molecular layers.

In some embodiments, the molecular crystal layer may have a van der Waals interaction with the two-dimensional material layer.

In some embodiments, the molecular crystal layer may have crystallinity due to a crystal structure of the two-dimensional material layer.

In some embodiments, the two-dimensional material layer may have a polycrystalline structure.

In some embodiments, the channel layer may include a first region overlapping the gate electrode and second regions overlapping the source electrode and the drain electrode.

In some embodiments, a material of the two-dimensional material layer of the first region of the channel layer may be different from a material of the two-dimensional material layer of the second regions of the channel layer.

In some embodiments, an electrical conductivity of the two-dimensional material layer of the second regions of the channel layer may be greater than or equal to an electrical conductivity of the two-dimensional material layer of the first region of the channel layer.

In some embodiments, the two-dimensional material layer of the second regions of the channel layer may further include a p-type dopant or an n-type dopant.

In some embodiments, the molecular crystal layer of the second regions of the channel layer may include a material configured to provide a p-type dopant or an n-type dopant to the two-dimensional material layer of the second regions of the channel layer.

In some embodiments, the material configured to provide the p-type dopant or the n-type dopant may include a plate-shaped aromatic compound including metal ions.

In some embodiments, the semiconductor device may have a planar FET structure, a fin FET (FinFET) structure, a gate all around FET (GAA FET) structure, or a complementary FET (CFET) structure.

According to an embodiment, an electronic apparatus may include the semiconductor device.

According to an example embodiment, a method of manufacturing a semiconductor device may include forming a channel layer on a substrate, the forming the channel layer including forming a two-dimensional material layer including a two-dimensional semiconductor material on the substrate and forming a molecular crystal layer including a plate-shaped aromatic compound of C₂₀-C₄₀ on the two-dimensional material layer; forming a gate insulating layer and a gate electrode on the channel layer; and forming a source electrode and a drain electrode respectively on both sides of the channel layer.

In some embodiments, the plate-shaped aromatic compound may have semiconductor characteristics.

In some embodiments, the plate-shaped aromatic compound may include a tetracene-based compound, a chrysene-based compound, a triphenylene-based compound, a pyrene-based compound, a perylene-based compound, a pentacene-based compound, a benzopyrene-based compound, a benzoperylene-based compound, or a coronene-based compound.

In some embodiments, the plate-shaped aromatic compound may include at least one of a hydroxyl group, a carboxyl group, a metal carboxylate group, an imide group, an amide group, and a carboxylic anhydride group (e.g., an acetic anhydride group).

In some embodiments, the molecular crystal layer may have a thickness of 1 molecular layer to 3 molecular layers.

In some embodiments, the two-dimensional semiconductor material may include a transition metal dichalcogenide (TMD) or black phosphorus.

In some embodiments, the two-dimensional material layer may include 1 molecular layer to 10 molecular layers.

In some embodiments, the molecular crystal layer may be deposited by atomic layer deposition (ALD), chemical vapor deposition (CVD), or evaporation.

In some embodiments, the channel layer may include a first region and second regions. The first region of the channel layer may overlap the gate electrode and the second regions of the channel layer may overlap the source electrode and the drain electrode, respectively

In some embodiments, a material of the two-dimensional material layer of the first region of the channel layer may be different from a material of the two-dimensional material layer of the second regions of the channel layer.

In some embodiments, a material of the molecular crystal layer of the first region of the channel layer may be different from the molecular crystal layer of the second regions of the channel layer.

### BRIEF DESCRIPTION OF THE DRAWINGS

The above and other aspects, features, and advantages of example embodiments of the disclosure will be more apparent from the following description taken in conjunction with the accompanying drawings, in which:
FIG. 1 is a cross-sectional view of a semiconductor device 100 according to an embodiment.
FIG. 2 is a conceptual diagram of a channel layer 130 according to an embodiment.
FIG. 3 illustrates molecular model diagrams of PDI, Me-PDI, and PTCDA, which are examples of compounds having a phenylene body among plate-shaped aromatic compounds capable of forming a molecular crystal layer 120.
FIGS. 4A to 4C are Scanning Tunneling Microscope (STM) images (left) of PDI, Me-PDI, and PTCDA layers deposited on MoS₂ layers on Si/SiO₂ substrates and molecular arrangement diagrams (right) inferred from the STM images, respectively.
FIG. 5A illustrates scanning electron microscope (SEM) images of the upper surface of a MoS₂/HfO₂ stacked structure on a Si/SiO₂ substrate, and FIG. 5B illustrates SEM images of the upper surface of a MoS₂/PDI/HfO₂ stacked structure on a Si/SiO₂ substrate.
FIGS. 6A to 6D illustrate atomic force microscope (AFM) images of a MoS₂ layer structure, a MoS₂/HfO₂ layer structure, a MoS₂/PTCDA layer structure and a MoS₂/PTCDA/HfO₂ layer structure, on a Si/SiO₂ substrate, respectively.
FIGS. 7A to 7E are cross-sectional views for explaining a method for manufacturing a semiconductor device, according to an embodiment.
FIG. 8 is a schematic cross-sectional view of a semiconductor device 200 according to another embodiment.
FIG. 9 is a schematic cross-sectional view of a semiconductor device 300 according to another embodiment.
FIG. 10A is a perspective view schematically illustrating a semiconductor device (FinFET, 500) according to another embodiment, and FIG. 10B is a cross-sectional view taken along the line A-A' of FIG. 10A.
FIG. 11A is a perspective view schematically illustrating a semiconductor device (MBCFET, 600) according to another embodiment, and FIG. 11B is a cross-sectional view taken along the line B-B' of FIG. 11A.
FIG. 12 is a conceptual diagram of a channel layer 630' according to another embodiment.
FIGS. 13 and 14 are conceptual diagrams schematically illustrating an electronic device architecture capable of being applied to electronic apparatuses, according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C" and "at least one of A, B, or C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified with "about" or "substantially," it will be understood that these values and shapes should be construed as including a manufacturing or operational tolerance (e.g., ±10%) around the stated numerical values or shapes. When ranges are specified, the range includes all values therebetween such as at increments of 0.1%.

Hereinafter, embodiments will be described in detail with reference to the attached drawings. In the drawings below, the same reference numerals refer to the same components, and the size of each component in the drawings may be exaggerated for clarity and convenience of explanation. The presented embodiments described below are merely non-limiting example, and various modifications are possible from these embodiments.

Hereinafter, the terms "over" or "on" may include not only things that are directly above, below, left, or right in contact, but also things that are indirectly above, below, left, or right in non-contact. Singular expressions include plural expressions unless context clearly dictates otherwise. Additionally, when a part is said to "include" a component, this does not mean that it excludes other components, but rather that it may include other components, unless otherwise specifically stated.

The use of the described term "above" and similar referential terms thereto may refer to both the singular and the plural. Unless steps constituting a method are explicitly described in order or are described to the contrary, these steps may be performed in any suitable order and are not necessarily limited to the order described.

Additionally, terms such as "section", "module", etc. described in the specification mean a unit that performs at least one function or operation, which may be implemented by hardware or software or may be implemented by a combination of hardware and software.

The connections or connection members of lines between components shown in the drawings illustratively represent functional connections and/or physical or circuit connections, and may be represented in an actual device as alternative or additional various functional connections, physical connections, or circuit connections.

Any use of examples is intended merely to describe technical ideas in detail and is not intended to limit the scope of the disclosure unless otherwise defined by the claims.

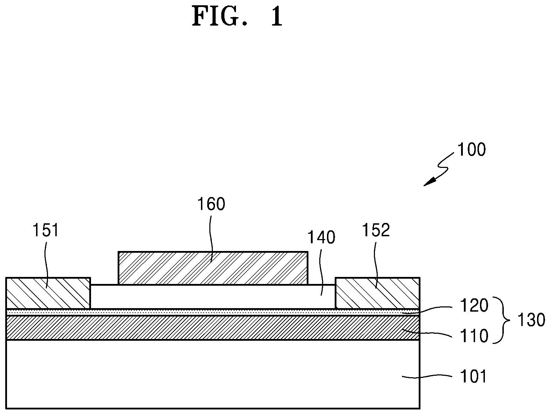

FIG. 1 is a cross-sectional view of a semiconductor device 100 according to an embodiment. The semiconductor device 100 shown in FIG. 1 may be, for example, a field effect transistor (FET).

Referring to FIG. 1, a channel layer 130 is provided on a substrate 101. The substrate 101 may include various materials such as a semiconductor material, an insulating material, and a metal material. The substrate 101 may also be a substrate for growth of a two-dimensional semiconductor material of the channel layer 130 to be described later.

The channel layer 130 may include a two-dimensional material layer 110 and a molecular crystal layer 120. The two-dimensional material layer 110 may include a two-dimensional semiconductor material. The two-dimensional semiconductor material refers to a semiconductor material having a two-dimensional crystal structure, and may have a layered structure. Each of the layers constituting this two-dimensional semiconductor material may have a thickness at an atomic level. For example, the two-dimensional semiconductor material may include 1 atomic layer to 3 atomic layers. The two-dimensional semiconductor material may have excellent electrical properties in a horizontal direction and can maintain high mobility without significant changes in their properties even when its thickness is reduced to a nanoscale.

The two-dimensional semiconductor material may include a material having a band gap of approximately 0.1 eV or more and 3.0 eV or less. For example, the two-dimensional semiconductor material may include, but is not limited to, a transition metal dichalcogenide (TMD).

TMD is a two-dimensional material having semiconductor properties and is a compound of a transition metal and a chalcogen element. Here, the transition metal may include, for example, at least one of Mo, W, Nb, V, Ta, Ti, Zr, Hf, Co, Tc and Re, and the chalcogen element may include, for example, at least one of S, Se and Te. As specific examples, TMDs may include, but are not limited to, MoS₂, MoSe₂, MoTe₂, WS₂, WSe₂, WTe₂, ZrS₂, ZrSe₂, HfS₂, HfSe₂, NbSe₂, ReSe₂, etc.

The two-dimensional material layer 110 may include (or be composed of), for example, 1 layer to 10 layers or 1 layer to 5 layers of the two-dimensional semiconductor material, but the disclosure is not limited thereto. The two-dimensional material layer 110 may have a thickness of, for example, about 0.1 nm to about 1 nm.

The molecular crystal layer 120 is a layer including molecular crystals, and is disposed on the two-dimensional material layer 110. The molecular crystals may be made of a plate-shaped aromatic compound. The plate-shaped aromatic compound refers to an aromatic compound having a two-dimensional structure. In other words, the plate-shaped aromatic compound has a planar core structure. The plate-shaped aromatic compound of the present embodiment may be, for example, a plate-shaped aromatic compound of C₂₀-C₄₀. The plate-shaped aromatic compound may include, for example, a tetracene-based compound, a chrysene-based compound, a triphenylene-based compound, a pyrene-based compound, a perylene-based compound, a pentacene-based compound, a benzopyrene-based compound, a benzoperylene-based compound, or a coronene-based compound. The plate-shaped aromatic compound may contain, for example, a hydroxyl group, a carboxyl group, a metal carboxylate group, an imide group, an amide group, or a carboxylic anhydride group.

Examples of the plate-shaped aromatic compound may include, but are not limited to, PDI (perylene diimide), Me-PDI (N,N'-dimethyl-3,4,9,10-perylenetetracarboxylic diimide), or PTCDA (perylenetetracarboxylic dianhydride).

The molecular crystal layer 120 may have a thickness of, for example, 1 molecular layer to 5 molecular layers or 1 molecular layer to 3 molecular layers. The molecular crystal layer 120 may have a thickness of, for example, about 0.1 nm to about 0.5 nm.

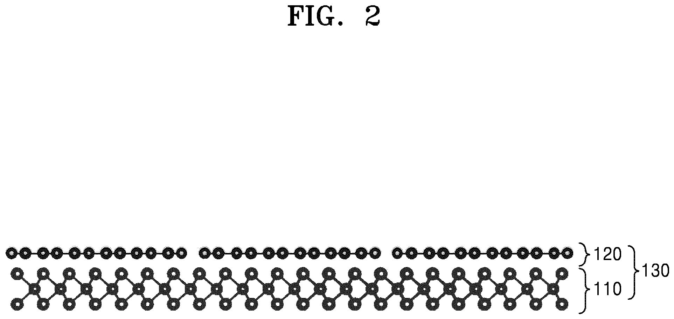

FIG. 2 is a conceptual diagram of a channel layer 130 according to an embodiment. Referring to FIG. 2, the molecular crystal layer 120 is formed on the two-dimensional material layer 110, and both the two-dimensional material layer 110 and the molecular crystal layer 120 are formed as a single layer. In FIG. 2, each spherical shape represents an element constituting a two-dimensional semiconductor material and a plate-shaped aromatic compound. Since the molecular crystal layer 120 is made of the plate-shaped aromatic compound according to the embodiment, it may have crystallinity due to the crystal structure of the two-dimensional material layer 110 on the two-dimensional material layer 110. The molecular crystal layer 120 has a crystal structure in which plate-shaped aromatic compounds are arranged regularly (e.g., in a specific pattern), and its crystal size may be smaller than or equal to the crystal size of the two-dimensional material layer 110.

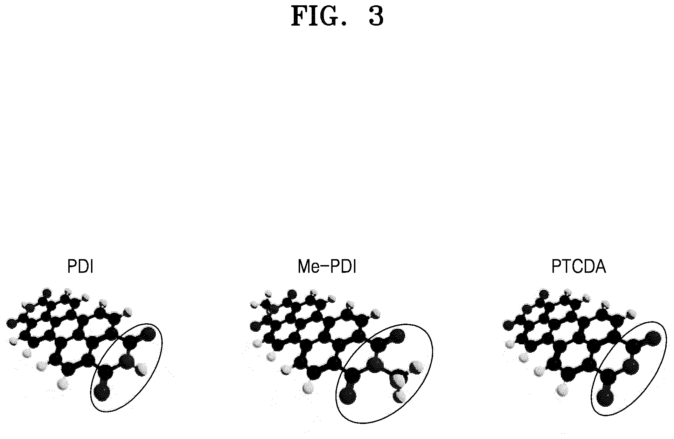

FIG. 3 illustrates molecular model diagrams of PDI, Me-PDI, and PTCDA, which are examples of compounds having a phenylene body among plate-shaped aromatic compounds capable of forming a molecular crystal layer 120. Referring to the molecular model diagrams of FIG. 3, it may be expected that each of the PDI, Me-PDI, and PTCDA molecules has an overall plate-like and rod-like shape and are stacked in layers. PDI, Me-PDI, and PTCDA differ in that the ends (circled) of the molecules have a diimide group, a methyldiimide group, and a carboxylic anhydride group, respectively.

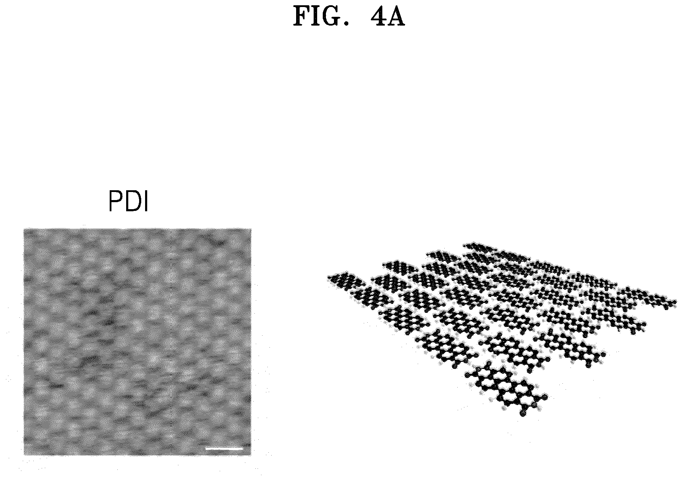

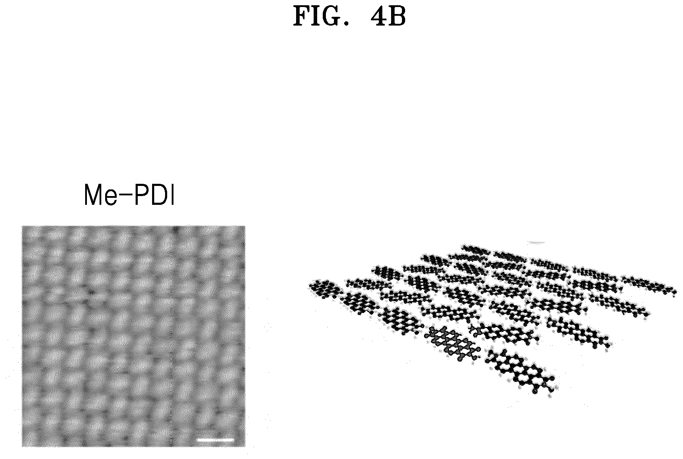

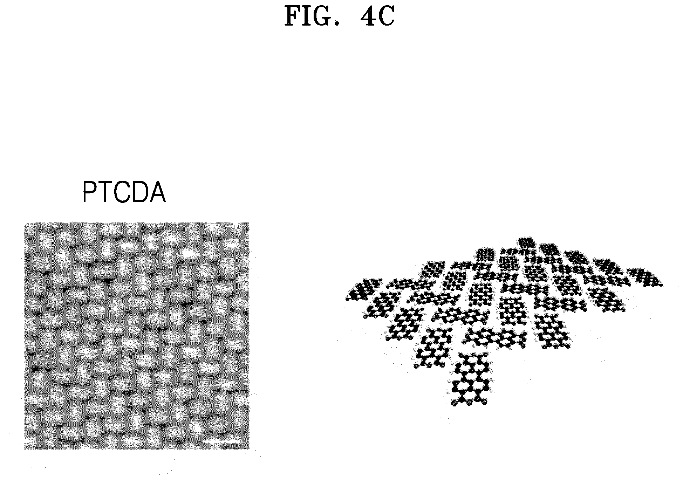

FIGS. 4A to 4C are STM images (left) of PDI, Me-PDI, and PTCDA layers deposited on MoS₂ layers on Si/SiO₂ substrates and molecular arrangement diagrams (right) inferred from the STM images, respectively. A MoS₂ layer was deposited as a single layer by MOCVD on a 2-inch silicon (Si) wafer substrate on which a silicon insulating layer (SiO₂) was formed, and PDI, Me-PDI, and PTCDA layers were deposited as single layers by evaporation on the MoS₂ layer, respectively.

Referring to FIGS. 4A to 4C, it appears that the molecules of the PDI, Me-PDI, and PTCDA layers are regularly arranged on the MoS₂ layer. It may be confirmed from this that the PDI, Me-PDI, and PTCDA layers have crystallinity. It is shown in FIGS. 4A to 4C that the PDI layer has a brick wall arrangement, the Me-PDI has a canted arrangement, and the PTCDA layer has a herringbone arrangement. The differences in molecular arrangements of PDI, Me-PDI, and PTCDA layers are presumed to be due to the difference in shapes of terminals of these molecules.

Channels made of a two-dimensional semiconductor material may have better scaling compared to silicon channels, but they may be damaged during a device manufacturing process due to their atomic-level thickness (e.g., three-atom-thick layers in the case of transition metal dichalcogenides). In addition, since there may be no dangling bonds on the surface of the two-dimensional semiconductor material, it may be difficult to deposit another material as a thin and uniform layer on the channels made of the two-dimensional semiconductor material via routes of dangling bonds. When depositing metal for source/drain contacts on two-dimensional semiconductor material channels, damages to the channels may increase contact resistance. In addition, it may be required to deposit a high-dielectric gate insulating layer more thinly and more uniformly between a channel and a gate electrode, but there may be a limit to the scaling of equivalent oxide thickness (EOT) due to the non-uniform deposition of the gate insulating layer. Additionally, interfacial trap density may increase due to damage that may occur in the channel during the formation of the gate insulating layer.

The molecular crystal layer of the present embodiment can be deposited thinner and more uniformly as a layer (e.g., a single layer) with crystallinity on a two-dimensional semiconductor material layer due to its structural characteristics having molecular crystals. Therefore, in a transistor manufacturing process, the presence of the molecular crystal layer on the two-dimensional semiconductor material layer enables a source/drain metal structure or a gate stacked structure to be formed more thinly and more uniformly. In addition, the molecular crystal layer may have improved chemical and thermal stability, so that a two-dimensional semiconductor material layer can be protected well when forming a structure on the two-dimensional semiconductor material layer. Due to the small thickness of the molecular crystal layer, there may be no deterioration in device characteristics even when it is used as an insertion layer on the two-dimensional semiconductor material layer.

Referring again to FIG. 1, a source electrode 151 and a drain electrode 152 may be provided on both sides of the channel layer 130. A gate insulating layer 140 may be provided on the channel layer 130 between the source electrode 151 and the drain electrode 152. A gate electrode 160 may be provided on the gate insulating layer 140.

The gate insulating layer 140 may include silicon oxide (SiO₂), silicon nitride (SiN), hafnium oxide (HfO₂), zirconium oxide (ZrO₂), aluminum oxide (Al₂O₃), yttrium oxide (Y₂O₃), and/or lanthanum oxide (La₂O₃), but the disclosure is not limited thereto. The gate insulating layer 140 may have a thickness of, for example, about 2 nm to about 20 nm or, for example, about 2 nm to about 10 nm.

The gate electrode 160 may include a metal material or a conductive oxide. Here, the metal material may include at least one selected from the group consisting of Au, Ti, TiN, TaN, W, Mo, WN, Pt, and Ni. The conductive oxide may include, for example, indium tin oxide (ITO), indium zinc oxide (IZO), etc. However, this is just illustrative.

The source electrode 151 and the drain electrode 152 may be provided at both sides of the gate electrode 160, respectively. The source electrode 151 and the drain electrode 152 are provided in the source region and drain region of the channel layer 130, respectively. Here, the source electrode 151 may be provided to contact the source region of the channel layer 130, and the drain electrode 152 may be provided to contact the drain region of the channel layer 130. The source electrode 151 and the drain electrode 152 may include a metal material having excellent electrical conductivity, such as Ag, Au, Pt, or Cu, but the disclosure is not limited thereto.

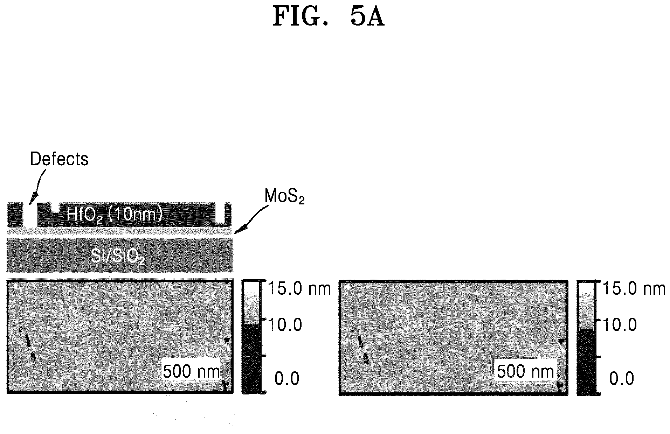

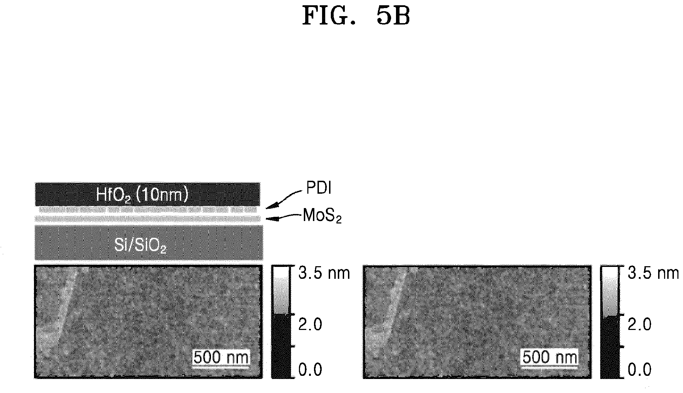

FIG. 5A illustrates SEM images of the upper surface of a MoS₂/HfO₂ stacked structure on a Si/SiO₂ substrate, and FIG. 5B illustrates SEM images of the upper surface of a MoS₂/PDI/HfO₂ stacked structure on a Si/SiO₂ substrate. In the stacked structure of FIG. 5A, the MoS₂ layer was deposited as a single layer, and the HfO₂ layer was deposited with a thickness of 10 nm. In the stacked structure of FIG. 5B, the MoS₂ layer and the PDI layer were each deposited as a single layer, and the HfO₂ layer was deposited with a thickness of 10 nm. In this case, the MoS₂ layer has a thickness of about 1 nm, and the PDI layer has a thickness of about 0.5 nm.

Referring to FIG. 5A, in the MoS₂/HfO₂ stacked structure where the HfO₂ layer is deposited with a thickness of 10 nm on the MoS₂ layer, there are portions (black portions) where HfO₂ is not deposited and portions (white portions) where HfO₂ is thickly deposited, thus indicating that HfO₂ is not uniformly deposited on the MoS₂ layer. Referring to FIG. 5B, in the MoS₂/PDI/HfO₂ stacked structure where the PDI layer is formed on the MoS₂ layer, the SEM images show an overall uniform color distribution, thus indicating that HfO₂ is more uniformly deposited.

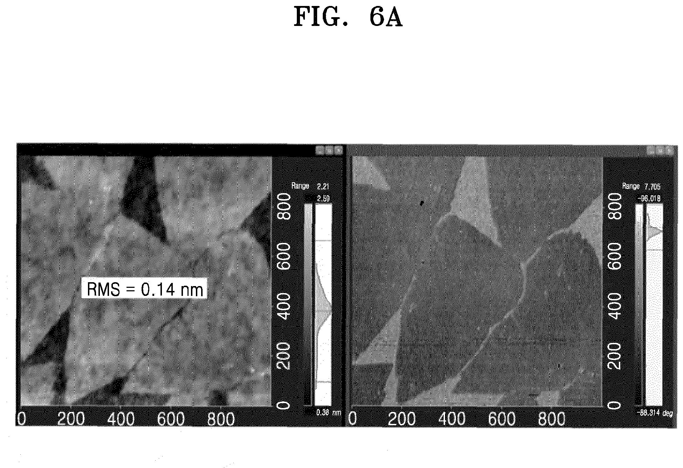

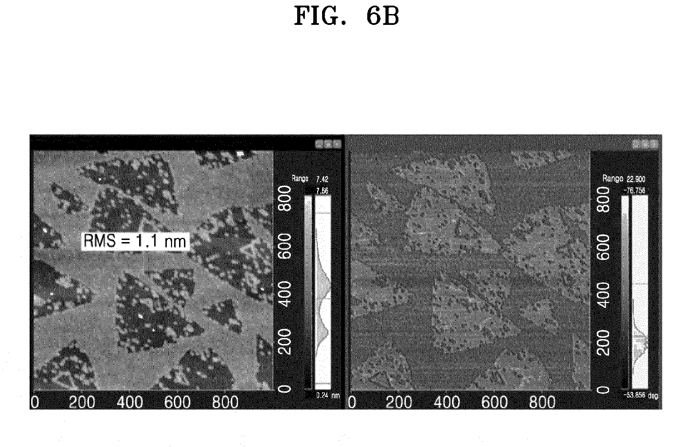

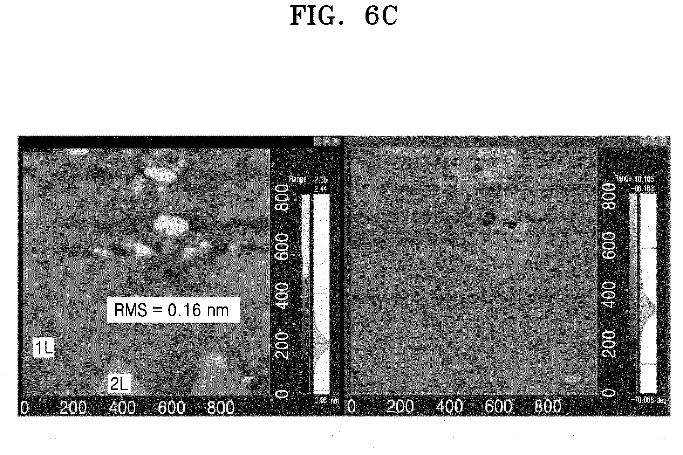

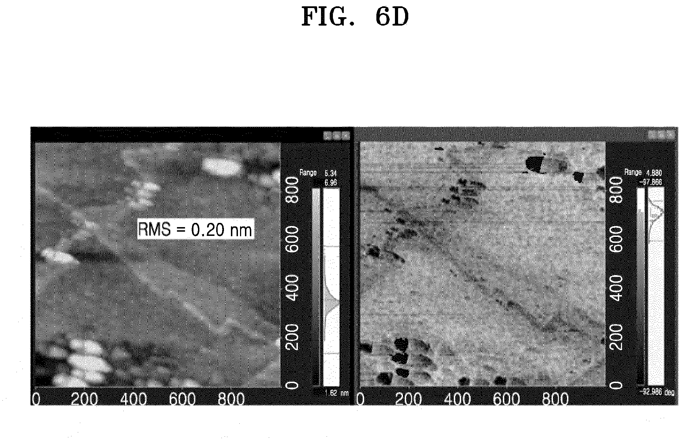

FIGS. 6A to 6D illustrate AFM images of a MoS₂ layer structure, a MoS₂/HfO₂ layer structure, a MoS₂/PTCDA layer structure, and a MoS₂/PTCDA/HfO₂ layer structure on a Si/SiO₂ substrate, respectively. In each of the structures of FIGS. 6A to 6D, the MoS₂ layer was formed as a single layer, the HfO₂ layer was deposited with a thickness of 3 nm, and the PTCDA was formed as a single layer. In the drawings of FIGS. 6A to 6D, the images on the left and right are images of the same object, with the left images being images based on the difference in surface height, and the right images being images based on the difference in surface material (difference in phase). Referring to FIGS. 6A to 6D, it can be seen that the differences in surface height and phase of the MoS₂/PTCDA/HfO₂ layer structure is smaller than that of the MoS₂/HfO₂ layer structure, and thus the surface height and phase appear more uniform.

Table 1 shows the area capacitance values (µF/cm²) measured for the HfO₂ layer, MoS₂+HfO₂ layer, and MoS₂+PDI+HfO₂ layer according to the thickness of HfO₂. The area capacitance was measured by positioning the structure in Table 1 between metal electrodes (gold). In Table 1, the effective oxide thickness represents a thickness of SiO₂ to have the same capacitance as HfO₂.

In the MoS₂+HfO₂ layer and MoS₂+PDI+HfO₂ layer, MoS₂ and PDI were each formed as a single layer, and HfO₂ was formed in a thickness value shown in Table 1. Referring to Table 1, in the structure of MoS₂+HfO₂, the capacitance was measured only when HfO₂ was formed to the largest thickness of 34 nm, and the capacitance was not measured due to short circuit when HfO₂ was formed to thicknesses of 13 nm, 7 nm, and 3 nm. This means that as thinner HfO₂ layer is formed on the MoS₂ layer, there are more portions where HfO₂ is not formed. On the other hand, in the structure of MoS₂+PDI+HfO₂, when PDI was formed on the MoS₂ layer, the capacitances were measured for HfO₂ of all thicknesses, and they were almost identical to the capacitance value for a single HfO₂ layer. This shows that thinner HfO₂ can be formed more reliably in the structure of MoS₂+PDI+HfO₂.

**[Table 1]**

| HfO₂ thickness (nm) | Effective oxide thickness (nm) | HfO₂ (µF/cm²) | MoS₂+HfO₂ (µF/cm²) | MoS₂+PDI+HfO₂ (µF/cm²) |
|---|---|---|---|---|
| 34 | 5 | 0.61±0.01 | 0.65±0.03 | 0.64±0.03 |
| 13 | 3 | 1.13±0.03 | short circuit | 1.39±0.09 |
| 7 | 2 | 1.79±0.02 | short circuit | 1.7±0.2 |
| 3 | 1.5 | 2.2±0.2 | short circuit | 2.2±0.3 |

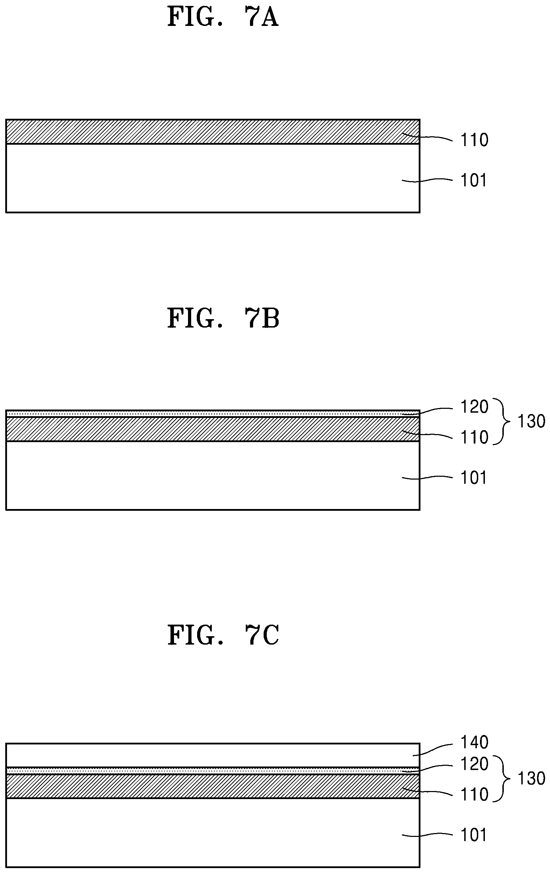

Hereinafter, a method of manufacturing the above-described semiconductor device 100 according to the embodiment will be described. FIGS. 7A to 7E are cross-sectional views for explaining a method for manufacturing a semiconductor device according to an embodiment.

Referring to FIG. 7A, a two-dimensional material layer 110 may be formed on a substrate 101. The substrate 101 may include various materials such as a semiconductor material, an insulating material, and/or a metal material. Here, the two-dimensional material layer 110 may be formed by depositing and growing a two-dimensional semiconductor material on the surface of the substrate 101. Deposition of the two-dimensional semiconductor material may be performed by, for example, chemical vapor deposition (CVD), physical vapor deposition (PVD), or the like, but example embodiments are not limited thereto.

TMD is a two-dimensional material having semiconductor properties and is a compound of a transition metal and a chalcogen element. Here, the transition metal may include, for example, at least one of Mo, W, Nb, V, Ta, Ti, Zr, Hf, Co, Tc, and Re, and the chalcogen element may include, for example, at least one of S, Se, and Te. Specific examples of the TMD may include MoS₂, MoSe₂, MoTe₂, WS₂, WSe₂, WTe₂, ZrS₂, ZrSe₂, HfS₂, HfSe₂, NbSe₂, ReSe₂, etc. However, example embodiments are not limited thereto.

The two-dimensional material layer 110 may have a single-layer or multi-layer structure, where each layer may have an atomic-level thickness. The two-dimensional material layer 110 may include, for example, 1 layer to 10 layers. For example, the two-dimensional material layer 110 may include 1 layer to 5 layers. However, example embodiments are not limited thereto.

Referring to FIG. 7B, a molecular crystal layer 120 is deposited on the two-dimensional material layer 110 to form a channel layer 130. The molecular crystal layer 120 may be formed of a plate-shaped aromatic compound of C₂₀-C₄₀ having a two-dimensional structure. The plate-shaped aromatic compound may include, for example, a tetracene-based compound, a chrysene-based compound, a triphenylene-based compound, a pyrene-based compound, a perylene-based compound, a pentacene-based compound, a benzopyrene-based compound, a benzoperylene-based compound, or a coronene-based compound. The plate-shaped aromatic compound may include, for example, a hydroxyl group, a carboxyl group, a metal carboxylate group, an imide group, an amide group, or a carboxylic anhydride group. Examples of the plate-shaped aromatic compounds may include, but are not limited to, PDI (perylene diimide), Me-PDI (N,N'-dimethyl-3,4,9,10-perylenetetracarboxylic diimide), and PTCDA (perylenetetracarboxylic dianhydride).

The molecular crystal layer 120 may be formed, for example, with a thickness of 1 molecular layer to 5 molecular layers or a thickness of 1 molecular layer to 3 molecular layers. The molecular crystal layer 120 may have a thickness of, for example, about 0.1 nm to about 0.5 nm.

Referring to FIG. 7C, a gate insulating layer 140 is deposited on the molecular crystal layer 120. The gate insulating layer 140 may be formed of, for example, at least one of silicon oxide (SiO₂), silicon nitride (SiN), hafnium oxide (HfO₂), zirconium oxide (ZrO₂), aluminum oxide (Al₂O₃), yttrium oxide (Y₂O₃), and lanthanum oxide (La₂O₃), or the like, but the disclosure is not limited thereto. The gate insulating layer 140 may be formed to a thickness of, for example, about 2 nm to about 20 nm or, for example, about 2 nm to about 10 nm.

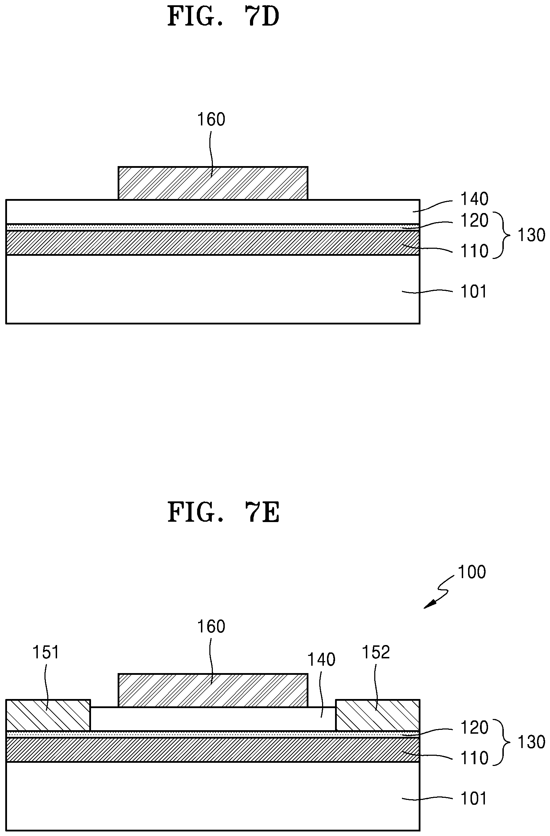

Referring to FIG. 7D, a gate electrode 160 is formed on the gate insulating layer 140. The gate electrode 160 may be formed of a metal material or a conductive oxide. The metal material may include at least one selected from the group consisting of Au, Ti, TiN, TaN, W, Mo, WN, Pt, and Ni. The conductive oxide may include, for example, at least one of indium tin oxide (ITO), indium zinc oxide (IZO), and the like. However, this is just illustrative.

Referring to FIG. 7E, a source electrode 151 and a drain electrode 152 are formed on both sides of the channel layer 130. The source electrode 151 and the drain electrode 152 are provided in the source region and drain region of the channel layer 130, respectively. The source electrode 151 may be provided to contact the source region of the channel layer 130, and the drain electrode 152 may be provided to contact the drain region of the channel layer 130.

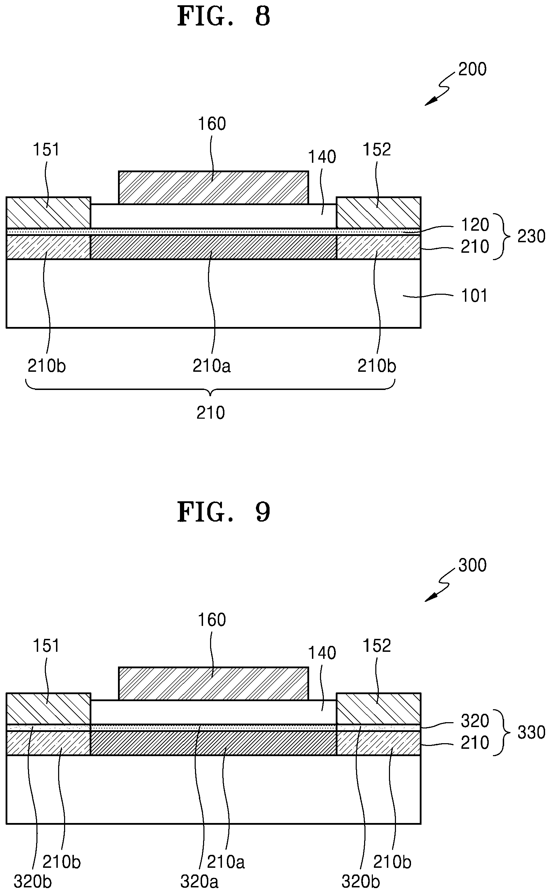

FIG. 8 is a schematic cross-sectional view of a semiconductor device 200 according to another embodiment. Hereinafter, differences from the above-described embodiment will be mainly described.

Referring to FIG. 8, a two-dimensional material layer 210 may include a first region 210a and second regions 210b provided at both sides of the first region 210a. The first region 210a of the two-dimensional material layer 210 may be located at the center portion of the two-dimensional material layer 210. The first region 210a of the two-dimensional material layer 210 may be a channel region corresponding to the gate electrode 160. The second regions 210b of the two-dimensional material layer 210 may be a source region and a drain region corresponding to the source electrode 151 and the drain electrode 152.

In the present embodiment, the first region 210a of the two-dimensional material layer 210 and the second regions 210b of the two-dimensional material layer 210 may be made of different materials from each other. For example, the two-dimensional semiconductor material of the second regions 210b of the two-dimensional material layer 210 may have higher conductivity than the two-dimensional semiconductor material of the first region 210a of the two-dimensional material layer 210. For example, the two-dimensional semiconductor material of the second regions 210b of the two-dimensional material layer 210 may be a two-dimensional semiconductor material doped with an n-type dopant or a p-type dopant. As the p-type dopant and the n-type dopant, for example, p-type dopants and n-type dopants used in graphene or carbon nanotubes (CNTs) may be used. Nb may be used as the p-type dopant, but the disclosure is not limited thereto. Re may be used as the n-type dopant, but the disclosure is not limited thereto. The p-type dopant or n-type dopant may be doped by ion implantation or chemical doping. Alternatively, the two-dimensional semiconductor material of the second regions 210b of the two-dimensional material layer 210 may be, for example, graphene or a metallic two-dimensional material. 1T-MoS2 or PtSe2 may be used as the metallic two-dimensional material, but the disclosure is not limited thereto. Contact resistance may be improved by increasing the conductivity of the second regions 210b, thus improving device performance.

FIG. 9 is a schematic cross-sectional view of a semiconductor device 300 according to another embodiment. Hereinafter, differences from the above-described embodiment will be mainly described.

Referring to FIG. 9, a molecular crystal layer 320 may include a first region 320a and second regions 320b provided at both sides of the first region 320a. The first region 320a of the molecular crystal layer 320 may be located at the center portion of the molecular crystal layer 320. The first region 320a of the molecular crystal layer 320 may be a channel region corresponding to the gate electrode 160. The second regions 320b of the molecular crystal layer 320 may be a source region and a drain region corresponding to the source electrode 151 and the drain electrode 152.

In the present embodiment, the first region 320a of the molecular crystal layer 320 and the second regions 320b of the molecular crystal layer 320 may be made of different materials from each other. In an embodiment, the plate-shaped aromatic compound of the second regions 320b of the molecular crystal layer 320 may include a compound capable of modulation-doping the second regions 210b of the two-dimensional material layer 210. For example, for modulation-doping, the second regions 320b may include a plate-shaped aromatic compound including metal ions. Examples of the metal ions may include Al³⁺, Mg²⁺, Mn²⁺, Zn²⁺, Co²⁺, Fe³⁺, Ni²⁺, and the like.

The conductivity of the second regions 210b of the two-dimensional material layer 210 can be increased by modulation-doping, thereby improving contact resistance and thus enhancing device performance. In an embodiment, the first region 320a of the molecular crystal layer 320 may not be doped.

In the above-described embodiments, semiconductor devices 100 to 300 having a planar structure were described as examples. However, the disclosure is not limited thereto, and for example, a semiconductor device having a Fin Field Effect Transistor (FinFET) structure or a semiconductor device having a Gate-All-Around FET (GAA FET) (e.g., Multi Bridge Channel FET (MBCFET)) or Complementary Field Effect Transistor (CFET) (e.g., Vertical CFET) structure may be provided.

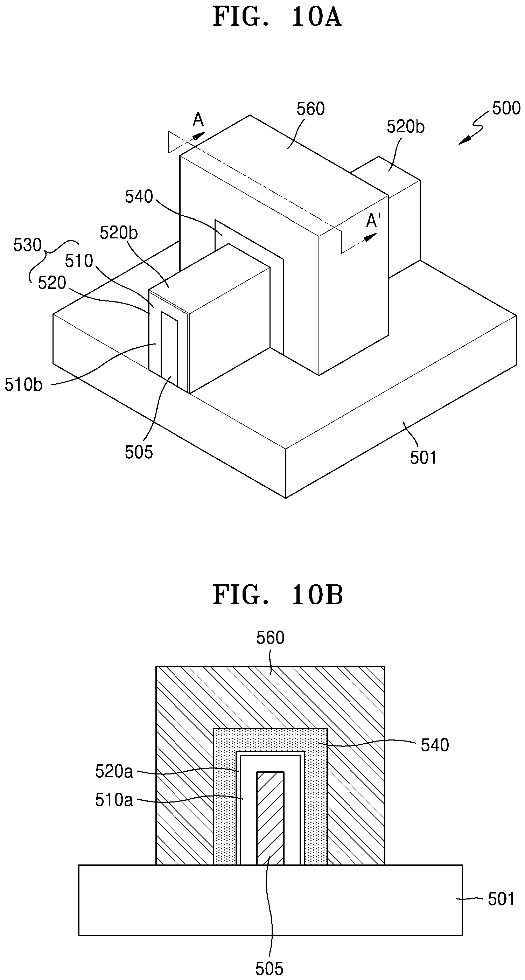

FIG. 10A is a perspective view schematically illustrating a semiconductor device (FinFET, 500) according to another embodiment, and FIG. 10B is a cross-sectional view taken along the line A-A' of FIG. 10A.

Referring to FIGS. 10A and 10B, an insulator 505 is provided on a substrate 501 and may be perpendicular to the substrate 501, and a channel layer 530 may be provided to cover the insulator 505. Here, the channel layer 530 may have a fin shape.

The channel layer 530 may include a two-dimensional material layer 510 and a molecular crystal layer 520. For the two-dimensional material layer 510 and the molecular crystal layer 520, refer to the above-described two-dimensional material layer 110 and molecular crystal layer 120.

The two-dimensional material layer 510 may include a first region 510a and second regions 510b provided at both sides of the first region 510a. Similarly, the molecular crystal layer 520 may include a first region 520a and second regions 520b provided at both sides of the first region 520a.

Three sides of the first region 510a of the two-dimensional material layer 510 and three sides of the first region 520a of the molecular crystal layer 520 are surrounded by a gate electrode 560, and may become channel regions. The second regions 510b of the two-dimensional material layer 510 and the second regions 520b of the molecular crystal layer 520 are located outside the gate electrode 560, and may become source/drain regions.

A gate insulating layer 540 is provided between the gate electrode 560 and the first region 520a of the molecular crystal layer 520. The gate insulating layer 540 is provided to surround three sides of the channel layer 530, specifically, the first region 520a of the molecular crystal layer 520, and the gate electrode 560 may be provided to surround three sides of the gate insulating layer 540. Although not shown in the drawings, source and drain electrodes may be provided in the second regions 520b of the molecular crystal layer 520.

In an embodiment, the first region 510a of the two-dimensional material layer 510 and the second regions 510b of the two-dimensional material layer 510 may be made of different materials from each other. For example, the two-dimensional semiconductor material of the second regions 510b of the two-dimensional material layer 510 may have higher conductivity than the two-dimensional semiconductor material of the first region 510a of the two-dimensional material layer 510. In this regard, refer to those described above with respect to the channel layer 230 of FIG. 8.

In another embodiment, the first region 520a of the molecular crystal layer 520 and the second regions 520b of the molecular crystal layer 520 may be made of different materials from each other. For example, the plate-shaped aromatic compound of the second regions 520b of the molecular crystal layer 520 may include a compound capable of modulation-doping the second regions 510b of the two-dimensional material layer 510. The first region 520a of the molecular crystal layer 520 may not be doped. In this regard, refer to those described above with respect to the channel layer 330 of FIG. 9.

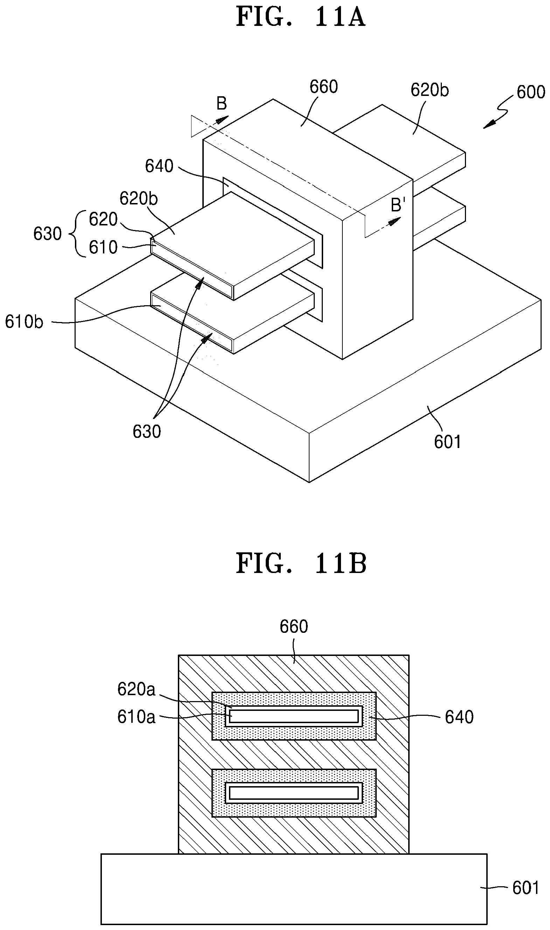

FIG. 11A is a perspective view schematically illustrating a semiconductor device (MBCFET, 600) according to another embodiment, and FIG. 11B is a cross-sectional view taken along the line B-B' of FIG. 11A.

Referring to FIGS. 11A and 11B, one or more channel layers 630 are arranged over a substrate 601 to be spaced apart from the substrate 601. Here, each of the channel layers 630 may have a sheet shape arranged parallel to the substrate 601. FIGS. 11A and 11B illustrate a case in which two channel layers 630 are arranged vertically over the substrate 601.

Each of the channel layers 630 may include a two-dimensional material layer 610 and a molecular crystal layer 620. For the two-dimensional material layer 610 and the molecular crystal layer 620, refer to the above-described two-dimensional material layer 110 and molecular crystal layer 120. In the present embodiment, since both the upper and lower surfaces of the channel layer 630 are in contact with a gate insulating layer 640, the molecular crystal layers 620 may be formed on both the upper and lower surfaces of the two-dimensional material layer 610.

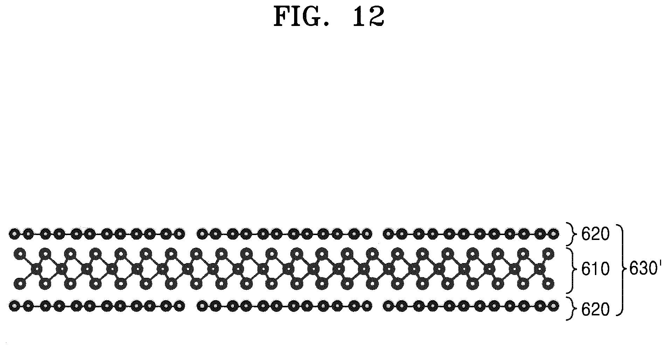

FIG. 12 is a conceptual diagram of a channel layer 630' according to another embodiment. Referring to FIG. 12, molecular crystal layer 620 are formed on and beneath a two-dimensional material layer 610, and both the two-dimensional material layer 610 and the molecular crystal layer 620 are formed as a single layer. In FIG. 12, each spherical shape represents an element constituting a two-dimensional semiconductor material and a plate-shaped aromatic compound. Since the molecular crystal layer 620 is made of the plate-shaped aromatic compound according to the embodiment, it may have crystallinity due to the crystal structure of the two-dimensional material layer 610. In other words, the channel layer 630' in FIG. 12 may include a two-dimensional material layer 610 sandwiched between a pair of molecular crystal layers 620. The channel layer 630' in FIG. 12 may replace any of the channel layers 130, 230, 330, 530, and 630 of the semiconductor devices 100 to 600 described above. Although not shown in the drawings, the channel layer 630' may include a first region between second regions, and materials of the two-dimensional material layer 610, or materials of the two-dimensional material layer 610 and molecular crystal layer 620 each respectively may be different materials in the first region and second regions of the channel layer 630'. In this regard, refer to those described above with respect to the channel layer 230 of FIG. 8 and the channel layer 330 of FIG. 9.

Referring again to FIGS. 11A and 11B, each of the two-dimensional material layers 610 may include a first region 610a and second regions 610b provided at both sides of the first region 610a. Similarly, each of the molecular crystal layers 620 may include a first region 620a and second regions 620b provided at both sides of the first region 620a.

Four sides of the first region 610a of the two-dimensional material layer 610 and four sides of the first region 620a of the molecular crystal layer 620 are surrounded by a gate electrode 660, and may become channel regions. The second regions 610b of the two-dimensional material layer 610 and the second regions 620b of the molecular crystal layer 620 are located outside the gate electrode 660, and may become source/drain regions.

A gate insulating layer 640 is provided between the gate electrode 660 and the first region 620a of the molecular crystal layer 620. The gate insulating layer 640 is provided to surround four sides of the channel layer 630, specifically, the first region 620a of the molecular crystal layer 620, and the gate electrode 660 may be provided to surround four sides of the gate insulating layer 640. Although not shown in the drawings, source and drain electrodes may be provided in the second regions 620b of the molecular crystal layer 620. It is also possible for an insulator (not shown) to be placed on the substrate 601 in parallel to the substrate 601 and for the channel layer 630 to be provided to surround the insulator.

The above-described semiconductor devices 100 to 600 may be applied to memory devices such as DRAMs. The memory device may have a structure in which the above-described semiconductor devices 100 to 600 are electrically connected with capacitors. Additionally, the semiconductor devices 100 to 600 may be applied to various electronic apparatuses. For example, the above-described semiconductor devices 100 to 600 may be used for arithmetic operations, program execution, temporary data retention, etc. in electronic apparatuses such as mobile devices, computers, laptops, sensors, network devices, neuromorphic devices, etc.

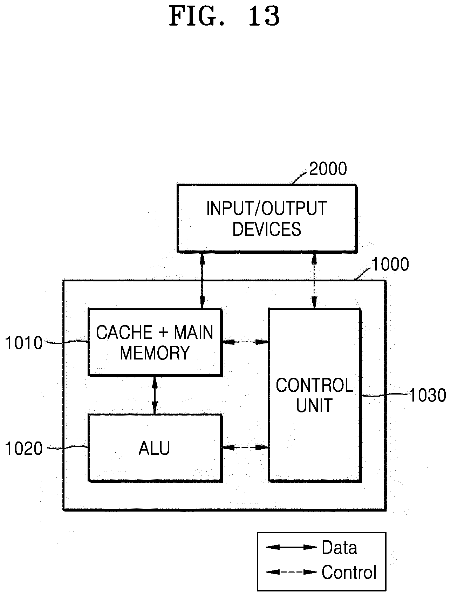

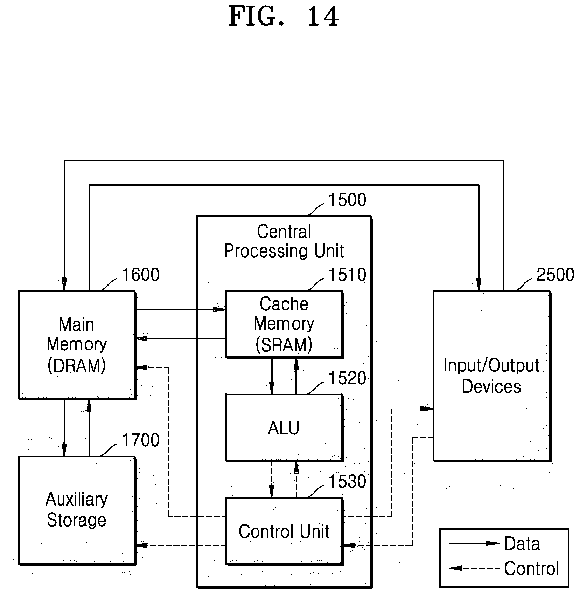

FIGS. 13 and 14 are conceptual diagrams schematically illustrating an electronic device architecture capable of being applied to electronic apparatuses according to an embodiment.

Referring to FIG. 13, an electronic device architecture 1000 may include a memory unit 1010, an arithmetic logic unit (ALU) 1020, and a control unit 1030. The memory unit 1010, the arithmetic logic unit (ALU) 1020, and the control unit 1030 may be electrically connected to each other. For example, the electronic device architecture 1000 may be implemented as a single chip including the memory unit 1010, the ALU 1020, and the control unit 1030.

Specifically, the memory unit 1010, the ALU 1020, and the control unit 1030 may be interconnected on-chip through metal lines to communicate directly. The memory unit 1010, the ALU 1020, and the control unit 1030 may be monolithically integrated on one substrate to form one chip. The electronic device architecture (chip) 1000 may be connected to input/output devices 2000 (e.g., keyboard, display, or mouse).

The ALU 1020 and the control unit 1030 may each independently include the above-described semiconductor devices 100 to 600, and the memory unit 1010 may include the semiconductor devices 100 to 600, capacitors, or a combination thereof. The memory unit 1010 may include both a main memory and a cache memory. This electronic device architecture (chip) 1000 may be an on-chip memory processing unit.

Referring to FIG. 14, a cache memory 1510, an ALU 1520, and a control unit 1530 may be part of a central processing unit (CPU) 1500. The cache memory 1510 may be formed of a static random access memory (SRAM), and may include the above-described semiconductor devices 100 to 600. In addition to the CPU 1500, a main memory 1600 and an auxiliary storage 1700 may be provided. The main memory 1600 may include a dynamic random access memory (DRAM) device.

In some cases, the electronic device architecture may be implemented in a form in which computing unit devices and memory unit devices are adjacent to each other on one chip, without distinction between sub-units. Although embodiments have been described above, they are merely exemplary, and various modifications can be made therefrom by those skilled in the art.

In the semiconductor device according to an embodiment, the presence of a molecular crystal layer on a two-dimensional material layer may enable a source/drain metal structure or a gate stacked structure to be formed more thinly and/or more uniformly. **In** addition, since the molecular crystal layer has improved or excellent chemical and/or thermal stability, it can protect the two-dimensional material layer better, and thereby prevent deterioration of device performances due to damage of the two-dimensional material layer.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a channel layer including a two-dimensional material layer and a molecular crystal layer on the two-dimensional material layer, the two-dimensional material layer including a two-dimensional semiconductor material;
a source electrode and a drain electrode, which respectively are on both sides of the channel layer; and
a gate insulating layer and a gate electrode on the channel layer between the source electrode and the drain electrode, wherein
the molecular crystal layer includes a plate-shaped aromatic compound of C₂₀-C₄₀, and
a thickness of the molecular crystal layer is 1 molecular layer to 5 molecular layers.

2. The semiconductor device of claim 1, wherein the plate-shaped aromatic compound has semiconductor characteristics; and/or
wherein the plate-shaped aromatic compound includes a tetracene-based compound, a chrysene-based compound, a triphenylene-based compound, a pyrene-based compound, a perylene-based compound, a pentacene-based compound, a benzopyrene-based compound, a benzoperylene-based compound, or a coronene-based compound; and/or
wherein the plate-shaped aromatic compound includes at least one of a hydroxyl group, a carboxyl group, a metal carboxylate group, an imide group, an amide group, and a carboxylic anhydride group; and/or
wherein the thickness of the molecular crystal layer is 1 molecular layer to 3 molecular layers; and/or
wherein the two-dimensional semiconductor material has a band gap of 0.1 eV to 3.0 eV.

3. The semiconductor device of claims 1 or 2, wherein
the two-dimensional semiconductor material includes a transition metal dichalcogenide (TMD) or black phosphorus;
preferably wherein
the transition metal dichalcogenide (TMD) includes a metal element and a chalcogen element,
the metal element includes at least one of Mo, W, Nb, V, Ta, Ti, Zr, Hf, Tc, and Re, and
the chalcogen element includes at least one of S, Se, and Te.

4. The semiconductor device of claim 3, wherein the transition metal dichalcogenide (TMD) includes MoS₂, MoSe₂, MoTe₂, WS₂, WSe₂, WTe₂, ZrS₂, ZrSe₂, HfS₂, HfSe₂, NbSe₂, ReSe₂, or any combination thereof; and/or
wherein the two-dimensional material layer includes 1 molecular layer to 10 molecular layers.

5. The semiconductor device of any of claims 1-4, wherein the molecular crystal layer has a van der Waals interaction with the two-dimensional material layer; and/or
wherein the molecular crystal layer has crystallinity due to a crystal structure of the two-dimensional material layer; and/or
wherein the two-dimensional material layer has a polycrystalline structure.

6. The semiconductor device of any of claims 1-5, wherein
the channel layer includes a first region and second regions,
the first region of the channel layer overlaps the gate electrode, and
the second regions of the channel layer overlap the source electrode and the drain electrode, respectively.

7. The semiconductor device of claim 6, wherein
a material of the two-dimensional material layer of the first region of the channel layer is different from a material of the two-dimensional material layer of the second regions of the channel layer; and/or
wherein an electrical conductivity of the two-dimensional material layer of the first region of the channel layer is greater than or equal to an electrical conductivity of the two-dimensional material layer of the second regions of the channel layer; and/or
wherein the two-dimensional material layer of the first region of the channel layer further includes a p-type dopant or an n-type dopant.

8. The semiconductor device of claims 6 or 7, wherein
the molecular crystal layer of the first region of the channel layer includes a material configured to provide a p-type dopant or an n-type dopant to the two-dimensional material layer of the first region of the channel layer, preferably wherein the material configured to provide the p-type dopant or the n-type dopant includes a plate-shaped aromatic compound including metal ions.

9. The semiconductor device of any of claims 1-8, wherein
the semiconductor device has a planar **FET** structure, a fin **FET** (FinFET) structure, a gate all around **FET** (GAA FET) structure, or a complementary **FET** (CFET) structure.

10. An electronic apparatus comprising:
the semiconductor device of any of claims 1-9.

11. A method of manufacturing a semiconductor device, the method comprising:
forming a channel layer on a substrate, the forming the channel layer including forming a two-dimensional material layer including a two-dimensional semiconductor material on the substrate and forming a molecular crystal layer including a plate-shaped aromatic compound of C₂₀-C₄₀ on the two-dimensional material layer;
forming a gate insulating layer and a gate electrode on the channel layer; and
forming a source electrode and a drain electrode respectively on both sides of the channel layer.

12. The method of claim 11, wherein the plate-shaped aromatic compound has semiconductor characteristics; and/or
wherein the plate-shaped aromatic compound includes a tetracene-based compound, a chrysene-based compound, a triphenylene-based compound, a pyrene-based compound, a perylene-based compound, a pentacene-based compound, a benzopyrene-based compound, a benzoperylene-based compound, or a coronene-based compound; and/or
wherein the plate-shaped aromatic compound includes at least one of a hydroxyl group, a carboxyl group, a metal carboxylate group, an imide group, an amide group, and a carboxylic anhydride group; and/or
wherein the molecular crystal layer has a thickness of 1 molecular layer to 3 molecular layers.

13. The method of claims 11 or 12, wherein the two-dimensional semiconductor material includes a transition metal dichalcogenide (TMD) or black phosphorus; and/or
wherein the two-dimensional material layer includes 1 molecular layer to 10 molecular layers; and/or
wherein the plate-shaped molecular crystal layer is deposited by atomic layer deposition (ALD), chemical vapor deposition (CVD), or evaporation.

14. The method of any of claims 11-13, wherein
the channel layer includes a first region and second regions,
the first region of the channel layer overlaps the gate electrode, and
the second regions of the channel layer overlap the source electrode and the drain electrode.

15. The method of claim 14, wherein a material of the two-dimensional material layer of the first region of the channel layer is different from a material of the two-dimensional material layer of the second regions of the channel layer; and/or
wherein a material of the molecular crystal layer of the first region of the channel layer is different from the molecular crystal layer of the second regions of the channel layer.
